# EUROPÄISCHE PATENTSCHRIFT

(11) **EP 1 913 179 B1**
(45) Veröffentlichungstag und Bekanntmachung des Hinweises auf die Patenterteilung: **23.06.2010**
(21) Anmeldenummer: 06776724.4
(22) Anmeldetag: 09.08.2006
(51) Int. Cl.: C25D 17/00, C25D 17/08, C25D 7/06

(54) **EINRICHTUNG ZUR AUFNAHME BZW. HALTERUNG MEHRERER SUBSTRATE UND GALVANISIEREINRICHTUNG**
DEVICE FOR PICKING UP AND HOLDING A PLURALITY OF SUBSTRATES AND AN ELECTROPLATING DEVICE
DISPOSITIF DESTINE A LOGER OU A MAINTENIR PLUSIEURS SUBSTRATS ET DISPOSITIF DE GALVANISATION

(30) Priorität: 09.08.2005 DE 102005039100
(43) Veröffentlichungstag der Anmeldung: 23.04.2008
(73) Patentinhaber: Gebr. Schmid GmbH + Co., 72250 Freudenstadt (DE)
(72) Erfinder: SCHMID, Christian, 72250 Freudenstadt (DE)
(74) Vertreter: Patentanwälte Ruff, Wilhelm, Beier, Dauster & Partner
(86) Internationale Anmeldenummer: PCT/EP2006/007903
(87) Internationale Veröffentlichungsnummer: WO 2007/017279

(56) Entgegenhaltungen:
- EP-A1- 0 239 736
- EP-A1- 0 819 781
- EP-A2- 0 992 617
- DE-C1- 4 330 346
- US-A- 4 192 729
- US-A- 5 135 636
- US-A- 6 080 289

## Beschreibung

### Anwendungsgebiet und Stand der Technik

Die Erfindung betrifft eine Einrichtung zur Aufnahme bzw. Halterung mehrerer flacher Substrate in einer horizontalen Ebene, sowie eine Galvanisiereinrichtung mit einer Durchlaufbahn für Substrate durch eine Behandlungskammer, wobei die Substrate in einer vorgenannten Einrichtung gehaltert sind.

Bislang wurden in Galvanisiereinrichtungen für Substrate, wie beispielsweise Leiterplatten oder vor allem Solarzellen bzw. -wafer, die Substrate auf Transportrollen liegend nach Art eines Rollenbandes transportiert. Dies kann jedoch Probleme bereiten bei sehr empfindlichen Substraten, wie beispielsweise dünnen Solarzellen. Hier können die Substrate aus sehr dünnem Silizium sein, welches dementsprechend empfindlich bzw. zerbrechlich ist. Des weiteren ist die Handhabung empfindlicher Substrate, beispielsweise beim Einbringen in eine Galvanisiereinrichtung, mit äußerster Sorgfalt vorzunehmen. Dies bedeutet in vielen Fällen entweder gesteigerten mechanischen Aufwand für die Greifvorrichtungen oder aber verlangsamte Handhabung, was ungewünschte Verzögerungen bedeutet.

Die DE 4330346 C1 zeigt eine Vorrichtung zur Aufnahme und Halterung einer Vielzahl flacher Substrate in einer horizontalen Ebene. Dabei sind die Substrate in Vertiefungen mit Haltemitteln angeordnet. Die Substrate werden dabei einzeln bearbeitet.

Die US-A-5 135 636 zeigt, wie Substrate in einer Vorrichtung zur Aufnahme und Halterung durch Klemmen von oben gehalten werden. Dabei wird pro Träger nur ein einziges Substrat gehalten.

Die EP-A1-0 239 736 zeigt eine Einrichtung zur Aufnahme und Halterung einer Vielzahl flacher Substrate in einer horizontalen Ebene, wobei die Substrate direkt geklemmt werden an einem äußeren Rand.

### Aufgabe und Lösung

Der Erfindung liegt die Aufgabe zugrunde, eine eingangs genannte Einrichtung zur Aufnahme bzw. Halterung mehrerer flacher Substrate zu schaffen sowie eine zu deren Bearbeitung geeignete Galvanisiereinrichtung, mit der Probleme des Standes der Technik vermieden werden können und insbesondere eine sorgfältigere Bearbeitung und Transport von Substraten möglich ist.

Gelöst wird diese Aufgabe durch eine Einrichtung mit den Merkmalen des Anspruchs 1 sowie eine Galvanisiereinrichtung mit den Merkmalen des Anspruchs 13. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Erfindungsgemäß weist die Einrichtung einen Rahmen mit Rahmenschenkeln auf, die Aufnahmefelder zwischen sich bilden, wobei durch die Rahmenschenkel Ausnehmungen bzw. Ausschnitte gebildet werden. Die Rahmenschenkel können also beispielsweise gitterartig verlaufen, insbesondere mit einem Außenrahmen und dazwischen verlaufenden Rahmenschenkeln als Unterteilungen. Die Rahmenschenkel weisen Auflagen für die Substrate auf, an bzw. auf denen die Substrate liegen. So erfolgt die mechanische Halterung der Substrate und eine elektrische Kontaktierung an die an den Auflagen anliegende Substratseite. So kann eine Aufnahme-Einrichtung bzw. Halterung für mehrere flache Substrate geschaffen werden, bei der die Substrate in die Aufnahmefelder eingelegt werden. Für verschiedene Behandlungsschritte der Substrate sowie für Transport und unter Umständen auch Lagerung brauchen nicht die einzelnen Substrate bewegt zu werden, sondern es wird die gesamte Aufnahme-Einrichtung bewegt. Diese kann weitaus robuster ausgeführt sein als die Substrate selber, so dass hier an sich übliche Greifvorrichtungen oder dergleichen problemlos verwendet werden können. Des weiteren kann durch die Auflagen eine genau definierte Verbindung zwischen Aufnahme-Einrichtung und Substrat vorliegen, die auf bestimmte Substrateigenschaften abgestimmt sein kann. Schließlich ist es durch eine Aufnahme-Einrichtung für eine Vielzahl von Substraten möglich, mit einzelnen Arbeitsschritten nicht nur ein Substrat zu bewegen, sondern gleich sämtliche Substrate einer Aufnahme-Einrichtung. Da über die Aufnahme-Einrichtung bzw. die Auflagen die elektrische Kontaktierung an die Substrate vorgenommen wird, werden zusätzliche Kontaktiereinrichtungen direkt an die Substrate eingespart. Dies weist darüber hinausgehend auch den Vorteil auf, dass die mechanische Belastung der Substrate durch Kontaktrollen oder sonstige Kontaktiereinrichtungen reduziert oder vermieden werden kann. Erfindungsgemäß erfolgt also durch die Aufnahme-Einrichtung sowohl eine mechanische Halterung bzw. Aufnahme der Substrate als auch eine elektrische Kontaktierung an diese.

Die Auflagen können beispielsweise als Vorsprünge ausgebildet sein, die von den Rahmenschenkeln abstehen oder ausgehen. Dabei können die Vorsprünge entweder relativ schmal ausgebildet sein, also nahezu punktförmig, um eine möglichst geringe Flächenabdeckung an den Substraten zu bewirken. So ist ein Kontakt mit einem Behandlungsmedium in einer Galvanisiereinrichtung vorteilhaft möglichst großflächig. Alternativ können die Vorsprünge aber auch breiter sein um eine Art linienförmige Auflage der Substrate mit ihrem Randbereich an den Aufnahmen bzw. Rahmenschenkeln zu bewirken. Hierdurch ist vor allem bei besonders empfindlichen Substraten eine ausreichend stabile Auflage möglich, weil sie verteilt ist. Die Vorsprünge können unterhalb der Ebene der Rahmenschenkel verlaufen, beispielsweise durch eine Abbiegung nach unten. Dadurch ist es möglich, dass die aufliegenden Substrate in etwa in einer Ebene mit der Halterung bzw. mit den Rahmenschenkeln liegen. Dabei können durchaus die Vorsprünge auch über die von der Unterseite der Rahmenschenkel gebildete Ebene nach unten überstehen. Vorteilhaft liegen die Substrate derart in der Aufnahme-Einrichtung bzw. auf den Vorsprüngen auf, dass ihre Oberseite nicht unter der Ebene der Oberseite der Rahmenschenkel liegt, sondern bevorzugt sogar ein kleines Stückchen übersteht. So kann gewährleistet werden, dass von oben anliegende Rollen odgl. auf alle Fälle auch an der oberen Seite der Substrate anliegen und nicht etwa hauptsächlich an Rahmenschenkeln, die die Substrate überragen.

Zur elektrischen Kontaktierung können an den Auflagen spezielle Kontakte vorgesehen sein, die nach oben stehen. Durch diese Kontakte, die insbesondere separat an den Vorsprüngen angebracht sein können, kann der elektrische Kontakt unabhängig von dem Material bzw. der Ausbildung der Vorsprünge verbessert werden. Kontakte können in Form von Kontaktvorsprüngen, Kontaktspitzen oder Kontaktköpfen vorliegen mit elektrisch leitfähigen Oberflächen. Insbesondere können die Kontakte aus vorteilhaft für Schaltkontakte verwendetem Kontaktmaterial bestehen. In einer Ausbildung der Erfindung ist es möglich, diese derart mit Dichtungen zu versehen, dass bei angelegten Substraten kein elektrischer Kontakt stattfindet. So können bei einem Galvanisiervorgang unerwünschte Ablagerungen an den Kontakten vermieden werden, da das Behandlungsmedium wegen der Dichtung nicht direkt an die Kontakte gelangen kann. Möglich sind hier beispielsweise topf- oder napfartige Gummidichtungen um die Kontakte herum.

Für eine elektrische Kontaktierung ist es von Vorteil, wenn manche oder alle Rahmenschenkel elektrisch leitfähig sind. Insbesondere ist die gesamte Aufnahme-Einrichtung elektrisch leitfähig, beispielsweise kann sie aus Metall bestehen. Vorteilhaft ist hierbei vorgesehen, dass sämtliche Teile bzw. Rahmenschenkel der Aufnahme-Einrichtung elektrisch leitend miteinander verbunden sind. Dazu kann eine solche Aufnahme beispielsweise nach Art eines gitterartigen Tabletts aus einem Blech herausgearbeitet sein.

In weiterer Ausgestaltung der Erfindung ist es möglich, die Aufnahme-Einrichtung mit einer elektrisch isolierenden Beschichtung zu versehen, beispielsweise einer Lackierung oder einem Überzug. So kann ein ungewünschtes Abscheiden von Beschichtungsmaterial bei einem Galvanisiervorgang an der gesamten Aufnahme vermieden werden. Findet dieses Abscheiden von Beschichtungsmaterial dann beispielsweise an den vorgenannten Kontakten als freiliegende Oberflächen der Aufnahme-Einrichtung statt, so müssen in gewissen zeitlichen Abständen diese Kontakte sozusagen gesäubert bzw. frei gestrippt werden, wie es dem Fachmann aus dem Stand der Technik bekannt ist.

Von der Einrichtung kann an einer Außenseite, insbesondere einem Außenbereich bzw. von einem außen verlaufenden Rahmenschenkel, ein Teil oder Abschnitt abstehen. Dieser ist vorteilhaft von der Ebene der im wesentlichen flaschen Einrichtung nach oben abgewinkelt, insbesondere mit einer daran anschließenden weiteren Abwinkelung noch einmal zur Seite hin. Ist dieser abstehende Abschnitt beispielsweise elektrisch leitfähig mit den Rahmenschenkeln bzw. den elektrischen Kontaktierungen für die Anlage der Substrate verbunden, so kann über den Abschnitt eine elektrische Kontaktierung an die Aufnahme-Einrichtung erfolgen. Dazu kann beispielsweise der Abschnitt aus demselben Material hergestellt werden wie die sonstige Einrichtung, beispielsweise aus dem vorgenannten Blech herausgearbeitet sein. Vorteilhaft ist es möglich, die gesamte Aufnahme-Einrichtung einteilig auszubilden bzw. einstückig. Des weiteren kann der Abschnitt auch dazu genutzt werden, die Aufnahme-Einrichtung zu greifen in einem Bereich, der etwas von der eingelegten Substraten entfernt ist. So können diese geschont werden.

In weiterer Ausgestaltung der Erfindung ist es möglich, die Aufnahme-Einrichtung so auszubilden, dass ein Substrat dichtend in einem Aufnahmefeld zwischen angrenzenden Rahmenschenkeln liegt. Werden also sämtlich Aufnahmefelder einer Aufnahme-Einrichtung mit Substraten belegt, so bilden sie eine im wesentlichen flüssigkeitsdichte Fläche. Die Anforderungen an eine Dichtheit sollte zumindest so sein, dass bei einem Bewegen durch das Behandlungsmedium bzw. ein Flüssigkeitsbad hindurch Flüssigkeit nicht von unten durch die Bereiche zwischen Substrat und Rahmenschenkel hindurchdringt, wobei dies für den Fall gilt, dass der Druck der Flüssigkeit von unten nur sehr gering ist. Dazu können beispielsweise Dichtungen entlang der Rahmenschenkel bzw. entlang der Bereiche vorgesehen sein, an denen die Substratseiten nahe an den Rahmenschenkeln liegen. Dadurch ist es möglich, die Oberseite der Substrate und auch der Aufnahme-Einrichtung frei von Behandlungsflüssigkeit zu halten. Dies ist insbesondere dann von Vorteil, wenn eine Behandlung bzw. Beschichtung nur an der nach unten weisenden Seite der Substrate erfolgen soll.

Vorteilhaft ist die Aufnahme-Einrichtung für lauter gleiche Substrate ausgebildet, wobei jedes Substrat gleichartig gehaltert ist. Dazu sind vorteilhaft sind mehrere Aufnahmefelder hintereinander und nebeneinander vorgesehen, beispielsweise mit einem insgesamt rechteckigen Feld.

In weiterer Ausgestaltung der Erfindung kann an der Aufnahme-Einrichtung eine Abdeckeinrichtung oder Abdeckung befestigt sein, insbesondere bewegbar bzw. gelenkig. In die Aufnahme-Einrichtung eingelegte Substrate können durch die Abdeckung befestigt bzw. gegen Herausfallen oder Herauslösen gesichert sein. Dabei kann die Abdeckung etwa die gleiche Fläche bedecken wie die Aufnahme-Einrichtung. Vorteilhaft weist sie einen ähnlichen Aufbau auf mit Schenkeln und dazwischenliegenden Feldern. Besonders vorteilhaft ist sie im wesentlichen ähnlich oder nahezu identisch ausgebildet wie die Aufnahme-Einrichtung. Sind die Substrate auch von oben in der Aufnahme-Einrichtung gehaltert bzw. gesichert, kann diese leichter bewegt werden, insbesondere auch vertikal gehalten oder sogar gedreht werden. Ist die Abdeckung an mehreren Stellen an der Aufnahme-Einrichtung befestigt, so kann sie wesentlich schwächer bzw. dünner ausgebildet sein, da sie nicht unbedingt eine eigene tragende Struktur bilden muss. Ihre Aufgabe ist es lediglich, die Substrate in den Aufnahmefeldern der Aufnahme-Halterung zu halten.

Für die erfindungsgemäße Galvanisiereinrichtung kann vorgesehen sein, dass die Substrate durch die Behandlungskammer laufen. Diese enthält ein Behandlungsmedium, beispielsweise einen Elektrolyten, zum galvanischen Aufbringen einer Schicht auf die Substrate. Die Substrate können dabei vorteilhaft dünne Leiterplatten sein oder alternativ dünne Solarzellen wie zuvor beschrieben. Die Durchlaufbahn weist dabei Transportmittel auf, beispielsweise Transportrollen, -räder odgl. Mit diesen wird die zuvor beschriebene Aufnahme-Einrichtung transportiert bzw. läuft auf der Durchlaufbahn durch die Behandlungskammer. Dabei können an den Aufnahme-Einrichtungen bzw. an den Substraten Andruckrollen oder -räder odgl. anliegen für verschiedene Aufgaben. Es kann vorgesehen sein, dass in Durchlaufrichtung pro hintereinander liegender Reihe von Substraten in der Aufnahme-Einrichtung mindestens eine derartige Andruckrolle vorgesehen ist. Falls die Substrate sehr empfindlich sind, wie zuvor ausgeführt, sind die Andruckrollen vorteilhaft besonders weich ausgebildet, um die Substrate nicht zu beschädigen.

Eine vorgenannte Aufnahme-Einrichtung steht seitlich über die Substratebene über bzw. von dieser weg, insbesondere gewinkelt nach oben. Der Winkelabschnitt reicht zu einer vorgenannten elektrischen Kontaktierung, wobei sich diese vorteilhaft nicht in Kontakt mit dem Behandlungsmedium befindet bzw. außerhalb der Galvanisiereinrichtung liegt. Besonders vorteilhaft ist dabei die Aufnahme-Halterung nach oben und dann zur Seite hin weggebogen, um mit dem Ende über die Galvanisiereinrichtung überzustehen. Eine elektrisch Kontaktierung kann durch anliegende Kontaktier-Rollen oder mitlaufende Kontakt-Klammern oder sonstige Kontakte wie auch Kontaktbürsten erfolgen.

Vorteilhaft ist vorgesehen, dass sich das Behandlungsmedium zwar an die Unterseite der durchlaufenden Substrate erstreckt bzw. an diese heranreicht. Um die Oberseite der Substrate trocken bzw. sauber zu halten, kann vorgesehen sein, dass das Höhenniveau relativ genau bis an die Unterseite der Substrate heranreicht. Dazu könnte auch eine Art Wellenbildung in dem Behandlungsmedium erfolgen, um durch schwache Wellen bzw. mit deren Wellenkämmen die Unterseite der Substrate zu erreichen. Alternativ kann es zu diesem Zweck vorgesehen sein, Substrate dichtend in der Aufnahme-Halterung anzuordnen, wie dies zuvor beschrieben worden ist.

Elektroden odgl. für den Galvanisierungsvorgang können unterhalb der Substrate vorgesehen sein. Falls die Substrate voll eingetaucht durch das Behandlungsmedium laufen, können auch darüber Elektroden vorgesehen sein.

In einer weiteren Ausführungsform der Erfindung können an der Oberseite der Aufnahme-Einrichtung, beispielsweise zwischen Andruckrollen, mehrere Kontaktiermittel angeordnet sein, die einen elektrischen Kontakt zu den Substraten bilden. Sie können als umlaufende Kontaktierrollen ausgebildet sein. Dazu können sie beispielsweise an Rahmenschenkeln anliegen, vorteilhaft in Transportrichtung verlaufen. Es ist besonders vorteilhaft mindestens ein Kontaktiermittel an jedem in Transportrichtung verlaufenden Rahmenschenkel vorgesehen.

Diese Rahmenschenkel, an denen die Kontaktiermittel anliegen, können vorteilhaft höher sein als die in der Aufnahme-Einrichtung befindlichen Substrate. Somit sind sie in der Regel über dem Niveau des Flüssigkeitsbades. Sie sind auch elektrisch leitfähig. Zur Kontaktierung der Substrate können neben einem eingangs genannten ganz leitfähigen Rahmen Kontaktbrücken vorgesehen sein, die von den Rahmenschenkeln mit den Kontaktiermitteln zu den darin befindlichen Substraten verlaufen. Sie können bügelartig oder brückenartig ausgebildet sein und von dem Rahmenschenkel beidseitig weg zu den Substraten führen, wobei dabei beispielsweise die Substrate auf Enden der Kontaktbrücken aufliegen können. So ist eine elektrische Kontaktierung der Substrate auch ohne leitfähigen Rahmen möglich.

Zwischen jeweils einem Paar von Andruckrollen kann eine Kontaktierrolle vorgesehen sein, vorzugsweise auf derselben Achse. Die Kontaktiermittel, vorzugsweise die Kontaktierrollen, können federnd bzw. elastisch ausgebildet sein, insbesondere mit von einem festen Mittelteil federnd abstehenden Kontaktierflächen. Sie können segmentiert sein, was aber in der Regel nur einer besser federnden Ausbildung dient.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im folgenden näher erläutert. In den Zeichnungen zeigt:
- Fig. 1: Eine Schrägansicht einer erfindungsgemäßen Aufnahme- Einrichtung,
- Fig. 2 u. 3: vergrößerte Detailansichten der Aufnahme-Einrichtung von Fig. 1,
- Fig. 4: eine Schnittdarstellung durch eine erfindungsgemäße Gal- vanisiereinrichtung für Solarzellen,
- Fig. 5: eine Seitenansicht der Galvanisiereinrichtung nach Fig. 4,
- Fig. 6: eine Schrägansicht einer weiteren erfindungsgemäßen Gal- vanisiereinrichtung und
- Fig. 7: eine vergrößerte Detailansicht der Kontaktierung an die Auf- nahme-Einrichtung von Fig. 6.

### Detaillierte Beschreibung des Ausführungsbeispiels

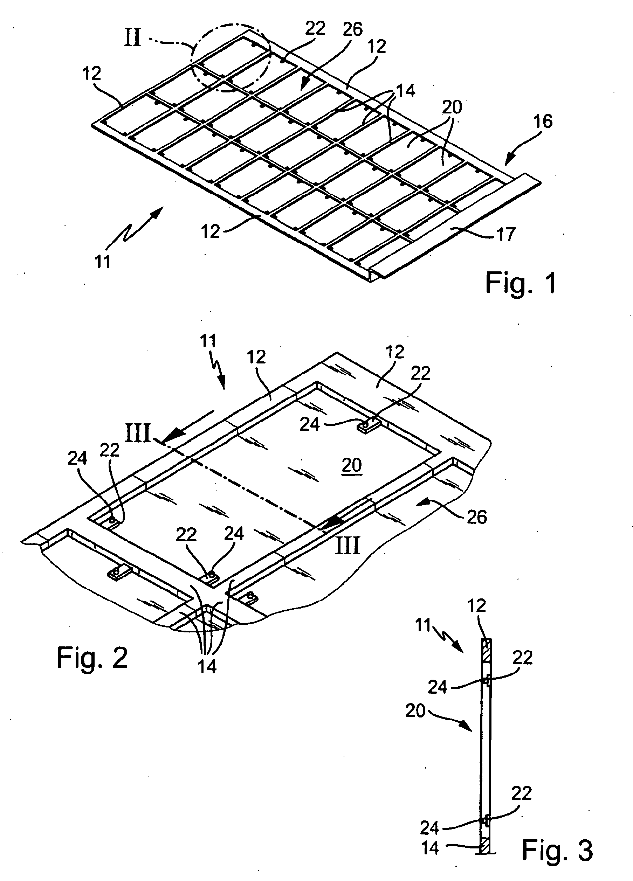

In Figur 1 ist in Schrägdarstellung eine Aufnahme-Einrichtung 11 dargestellt, die in etwa nach Art eines Tabletts ausgebildet ist. Außen verlaufende Außen-Rahmenschenkel 12 und dazwischen verlaufende Innen-Rahmenschenkel 14 bilden eine Art Gitter mit Ausnehmungen dazwischen, welche Aufnahmefelder 20 darstellen. Es ist zu erkennen, dass sämtliche Aufnahmefelder 20 zwischen den Rahmenschenkeln 12 und 14 gleich groß sind. Dies kann auch anders sein.

An der nach rechts weisenden Seite ist ein Winkelabschnitt 16 vorgesehen. Hier ist der Außen-Rahmenschenkel 12 zuerst nach oben und dann mit einem Randstreifen 17 wieder zur Seite hin abgewinkelt. Die Aufnahme-Einrichtung 11 kann aus Metall bestehen, insbesondere aus Metallblech gefertigt sein. Des weiteren kann sie im wesentlichen isolierend beschichtet sein mit einer Beschichtung oder einem Lack, der resistent ist gegenüber üblicherweise beim Galvanisieren eingesetzten Behandlungsmedien. Der Randstreifen 17 ist zumindest an einer Seite frei bzw. weist eine elektrisch leitfähige Oberfläche auf, vorteilhaft auf seinen beiden Seiten.

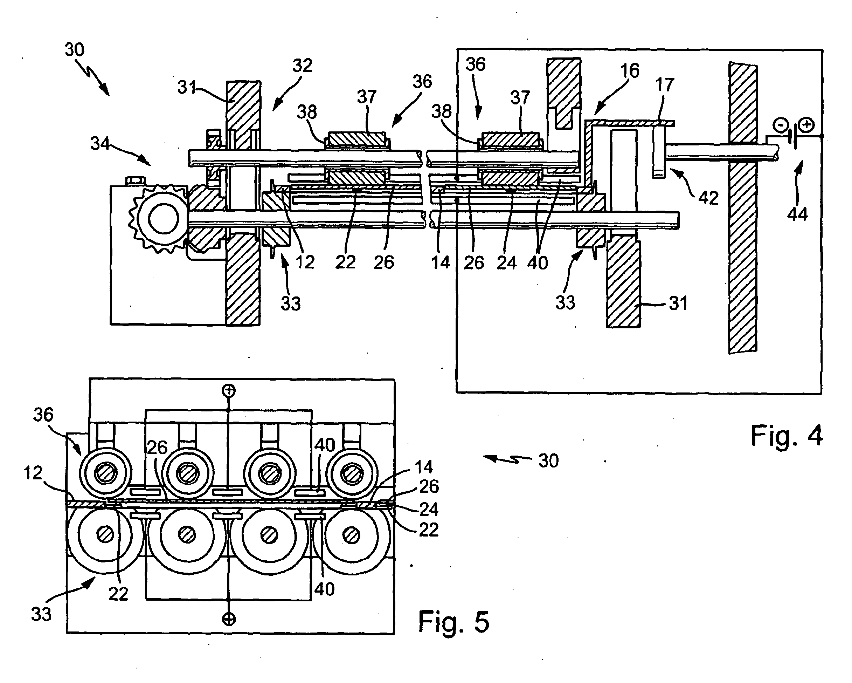

Insbesondere aus der Vergrößerung in den Fig. 2 und 3 ist zu erkennen, wie von den Rahmenschenkeln 12 und 14 an einigen Stellen Vorsprünge 22 abstehen. Diese können entweder nachträglich an den Rahmenschenkeln befestigt werden, beispielsweise durch Festschweißen. Alternativ können sie durch einen Stanzvorgang odgl. aus einem einzigen Metallblech zusammen mit den Rahmenschenkeln herausgearbeitet sein. Aus der Schnittdarstellung in Fig. 3 ist zu erkennen, dass die Dicke der Vorsprünge 22 geringer ist als diejenigen der Rahmenschenkel, insbesondere sind sie nur halb so dick. Damit wird bezweckt, dass bei den auf am Ende der Vorsprünge 22 angeordneten Kontakten 24 aufliegenden Solarzellen bzw. Siliziumwafern 26, wie dies in Fig. 2 gestrichelt dargestellt ist, die Oberseite der Solarzellen nicht all zu weit über die Oberseite der Aufnahme-Einrichtung 11 bzw. der Rahmenschenkel 12 und 14 übersteht. Dies wird nachfolgend zu Fig. 4 und 5 noch näher erläutert.

Die Kontakte 24 können beispielsweise Kontaktpunkte oder Kontaktspitzen sein und aus einem üblicherweise für Schaltkontakte odgl. verwendeten Kontaktmaterial bestehen, also aus anderem Material als die Vorsprünge 22 selbst. Dies hat den Vorteil, dass dadurch eine noch bessere Kontaktierung an die Solarzellen 26 oder sonstige in die Aufnahmefelder 20 einzulegende Substrate möglich ist.

In alternativen Ausgestaltungen der Erfindung können anstelle der einzelnen, relativ kleinen Vorsprünge 22 breite Streifen von den Rahmenschenkeln 12 und 14 abstehen. Diese ermöglichen eine breite Auflage der Solarzellen 26 und somit eine bessere mechanische Abstützung. Des weiteren können auch pro Aufnahmefeld 20 mehr als die dargestellten drei Vorsprünge 22 vorgesehen sein, insbesondere verteilt an allen Rahmenschenkeln entlang. Der Vorteil einer geringen Anzahl von Vorsprüngen 22 liegt zum einen in der einfacheren Herstellung. Zum anderen wird dadurch das Behandlungsmedium möglichst gut an die Unterseite der Substrate bzw. Solarzellen gelassen.

In noch weiterer Ausgestaltung der Erfindung ist es denkbar, an den Vorsprüngen 22 um die Kontakte 24 herum runde Dichtungen odgl. derart vorzusehen, dass die Kontakte 24 in einem im wesentlichen punktartigen Bereich an den Solarzellen 26 anliegen. Dieser Anlagebereich wird durch die Dichtung umgeben und nach außen abgeschirmt, wobei die Dichtung möglichst nahe an den Kontakten verlaufen sollte um den Anlagebereich möglichst klein zu halten. In diesem Fall sind die Kontakte davor geschützt, mit dem Behandlungsmedium in Berührung zu kommen, und werden so auch nicht beschichtet. Die genaue Ausgestaltung solcher Dichtungen ist für den Fachmann allgemein bekannt und problemlos durchzuführen.

In der Darstellung einer Galvanisiereinrichtung 30 in Fig. 4 bilden Wandungen 31 eine Behandlungskammer 32. In dieser befindet sich ein Elektrolyt als Behandlungsmedium, in dem Metall gelöst ist, welches auf die Solarzellen 26 abgeschieden werden soll. Die Aufnahme-Einrichtungen 11 nach Fig. 1 werden auf Transportrollen 33 liegend durch die Galvanisiereinrichtung 30 transportiert. Dabei werden die Transportrollen 33 durch einen Antrieb 34 angetrieben. Wie aus Fig. 5 zu erkennen ist und allgemein bekannt ist, sind eine Vielzahl von Transportrollen 33 hintereinander angeordnet und bilden eine Durchlaufbahn für die Aufnahme-Einrichtungen 11 bzw. die Solarzellen 26.

Die Aufnahme-Einrichtung 11 ist an jedem Aufnahmefeld 20 mit einer Solarzelle 26 belegt. In der Galvanisiereinrichtung 30 liegen die Andruckrollen 36 an der oberen Seite der Solarzellen 26 an. Diese bestehen aus einem sehr weichen Gummibelag 37 auf einem Metallkern 38, wobei sie ebenfalls über den Antrieb 34 angetrieben werden. Dabei sind die Andruckrollen 36 derart angeordnet, dass sie jeweils relativ genau mittig entlang der Reihen von hintereinander angeordneten Solarzellen 26 aufliegen. Die Andruckrollen 36 haben die Aufgabe, die Solarzellen 26 in der Aufnahme-Einrichtung 11 bzw. den Aufnahmefeldern 20 zu halten und dabei das Anliegen der Kontakte 24 an der Unterseite zu gewährleisten.

Der Winkelabschnitt 26 der Aufnahme-Einrichtung 11 steht nach oben zumindest über die Höhe des Behandlungsmediums in der Behandlungskammer 32 über. Der nach rechts abragende Randstreifen 17 ragt dabei über die rechte Wandung 31 hinaus. An seiner Unterseite liegt eine Kontaktrolle 42 kontaktierend an. Ähnlich wie die Transportrollen 33 und Andruckrollen 36 in Fig. 5 ist auch eine Vielzahl von Kontaktrollen 42 entlang der Durchlaufbahn vorgesehen. Über diese ist stets der elektrische Kontakt an den Randstreifen 17 und somit an die Aufnahme-Einrichtung 11 gewährleistet. Die Kontaktrolle 42 wiederum ist mit einer Stromquelle 44 bzw. deren Minus-Pol verbunden. Der Plus-Pol der Stromquelle 44 ist mit länglichen Elektroden 40 verbunden, die zwischen den jeweiligen Rollen oberhalb und unterhalb der Solarzellen 26 in der Behandlungskammer 32 angeordnet sind.

### Funktion

Zur Behandlung von Solarzellen 26 werden diese in eine Aufnahme-Einrichtung 11 eingelegt. Dabei erfolgt eine elektrische Kontaktierung von den Solarzellen 26 an die Aufnahme-Einrichtung 11 über die an der Unterseite anliegenden Kontakte 24. Mit einer nicht dargestellten Abdeckeinrichtung odgl. können die Solarzellen 26 fest in den Aufnahmefeldern 20 gehalten werden, beispielsweise durch einen weiteren gitterartigen Rahmen, Klammern odgl.. In weiterer Ausgestaltung der Erfindung können Federn odgl. vorgesehen sein, die die Solarzellen 26 in die Aufnahmefelder 20 bzw. gegen die Kontakte 24 drücken, wobei sie selbsttätig beim Einlegen der Substrate verriegeln. Schließlich könnten auch kleine Saugnäpfe, eine Vakuumhalterung odgl. vorgesehen sein, beispielsweise im Bereich der Vorsprünge 22. Sie können auch die Kontakte 24 gleichzeitig mit der oben beschriebenen Dichtfunktion umschließen.

Die Solarzellen 26 bestehen vorteilhaft aus Silizium bzw. sind Siliziumwafer. Diese werden bislang für ihre Funktion teilweise mit Silberpaste als Kontaktmaterial aufwendig bedruckt. Die Galvanisiereinrichtung 30 ist vorgesehen um die Kontaktschicht galvanisch abzuscheiden, insbesondere auf die Vorderseite der Solarzellen. Somit enthält also das Behandlungsmedium in der Behandlungskammer 32 einen entsprechenden Anteil an Kontaktmaterial, beispielsweise Silber.

Dann wird die mit den Solarzellen 26 beladene Aufnahme-Einrichtung 11 in die Galvanisiereinrichtung 30 eingebracht. Die Aufnahme-Einrichtung 11 fährt dabei entlang der Durchlaufbahn auf den Transportrollen 33 durch die Behandlungskammer 32. Soll eine Abscheidung von Silber nur an der Unterseite der Solarzellen 26 erfolgen, so kann das Höhenniveau des Behandlungsmediums entsprechend gewählt werden bzw. das Behandlungsmedium sollte möglichst nur an die Unterseite der Solarzellen 26 reichen.

Die Solarzellen 26 sind mit ihrer Unterseite über die Kontakte 24 und die Vorsprünge 22 sowie die Rahmenschenkel 12 und 14 mit dem Winkelabschnitt 16 bzw. dem Randstreifen 17 elektrisch leitfähig verbunden. Da an den Randstreifen 17 die Kontaktrollen 42 reichen, die wiederum mit dem Minus-Pol der Stromquelle 44 verbunden sind, liegen die Unterseiten der Solarzellen 26 auf diesem Potential. Über die Elektroden 40, die mit dem Plus-Pol der Stromquelle 44 verbunden sind, wird Spannung angelegt bzw. das Potentialgefälle zu den Solarzellen 26 aufgebaut zur Abscheidung von Silber aus dem Behandlungsmedium heraus auf der Unterseite der Solarzellen 26. Prozessparameter wie Durchlaufgeschwindigkeit und Zusammensetzung des Behandlungsmediums sowie Betrieb der Stromquelle 44 sind je nach Anwendungsfall geeignet zu wählen und stellen für den Fachmann kein Problem dar. Nach ausreichender Silberabscheidung bzw. -beschichtung wird die Aufnahme-Einrichtung 11 mit den Solarzellen 26 aus der Galvanisiereinrichtung 30 entnommen oder herausgefahren. Anschließend kann eine weitere Behandlung folgen oder aber auch eine Zwischenlagerung. Dabei ist es möglich, die Solarzellen 26 so lange, wie sie nicht einzeln benötigt oder bearbeitet werden, in der Aufnahme-Einrichtung 11 zu belassen. Dort sind sie leicht zu transportieren, leicht aufzubewahren und vor Beschädigung geschützt.

Da sich an den Aufnahme-Einrichtungen 11 zumindest an den Kontakten 24, wenn sie ungeschützt sind, ebenfalls Beschichtungsmaterial abscheidet, sind diese in gewissen Zeitabständen von der Beschichtung zu befreien. Dieser Vorgang wird unter Fachleuten auch "Entstrippen" genannt. Insofern ist es vorteilhaft, wenn die Aufnahme-Einrichtung 11 nur im Bereich der Kontakte 24 sowie des Randstreifens 17 eine elektrisch leitfähige Oberfläche hat, da dann in den übrigen Bereichen keine Beschichtung stattfinden kann. Alternativ zu der vorgenannten Entfernung einer Beschichtung kann dies auch nasschemisch erfolgen.

In Fig. 4 ist zu erkennen, wie die Andruckrollen 36 jeweils die Solarzellen 26 in die Aufnahmefelder 20 drücken. Da die Oberseite der Solarzellen 26 leicht über die Oberseite der Rahmenschenkel 12 und 14 übersteht, ist gewährleistet, dass die Andruckrollen 36 stets auf den Substraten bzw. Solarzellen 26 anliegen und diese somit nach unten gegen die Kontakte 24 drücken.

Zusätzlich zu der Stromquelle 44 können Lichtquellen unterhalb der Solarzellen 26 vorgesehen sein. Diese können durch Bestrahlung der Solarzellen 26 von unten mit Licht geeigneter Wellenlänge, vorzugsweise in einem Wellenlängenbereich zwischen 400 nm und 1100 nm, den Beschichtungsprozess unterstützen. Unter Umständen ist es sogar denkbar, nur durch Lichtquellen den notwendigen Galvanisierstrom zu erzeugen. Vorteilhaft jedoch wird zumindest eine derartige lichtinduzierte Stromerzeugung mit einer vorgenannten gesteuerten Stromquelle kombiniert.

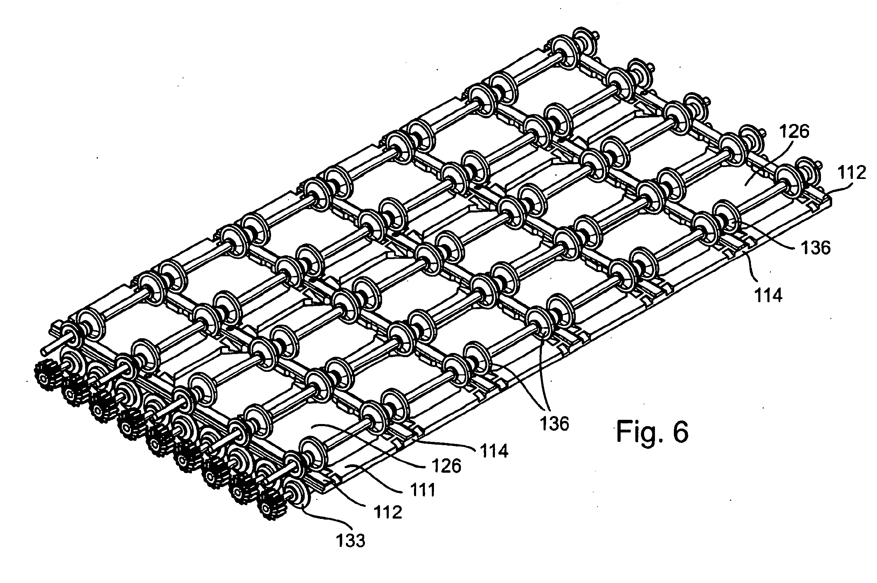

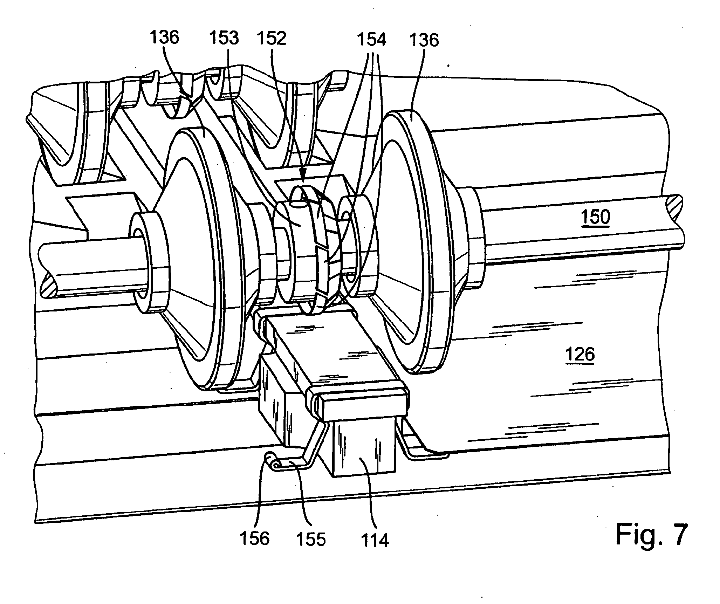

Bei der alternativen Ausführung gemäß der Fig. 6 und 7 wird eine rahmenartige Aufnahme-Einrichtung 111 mit Außen-Rahmenschenkeln 112 und Innen-Rahmenschenkeln 114 mit Substraten 126 belegt. Sie4 werden von Transportrollen 133 transportiert durch eine Anlage ähnlich wie zuvor beschrieben. Die Substrate 126 werden von Andruckrollen 136 in der Aufnahme-Einrichtung 111 gehalten. Die Andruckrollen 136 sitzen auf denselben Achsen 150 wie dazwischen vorgesehene Kontaktierrollen 152. Diese weisen von einem Mittelteil 153 abstehende, federnde Kontaktfelder 154 auf. Die Kontaktierrollen 152 bzw. die Kontaktfelder 154 liegen an der Oberseite der Rahmenschenkel 114 an. Diese sind durchgehend elektrisch leitfähig oder weisen eine entsprechende Beschichtung oder Auflage auf.

Von diesen elektrisch leitfähigen Rahmenschenkeln 114 gehen Kontaktbrücken 155 beidseitig ab. Sie können auch alternativ als Bügel oder mit einer ähnlichen gleich funktionierenden Form versehen sein. Die Kontaktbrücken 155 gehen in Enden 156 über, auf denen letztendlich die Substrate 126 aufliegen und so elektrisch kontaktiert werden wie zuvor mit den Kontakten 24.

Vorteil ist hier, dass eine elektrische Kontaktierung an den Rahmen flächig verteilt und auch zentral erfolgt, nicht nur von einer Seite aus. Es gibt so keine Stromgradienten. Bei lokalen Verunreinigungen an einer Kontaktfläche ist auch viel weniger Gefahr einer Unterbrechung der Stromzufuhr. Auch ist die individuelle Bestromung aller Rahmenschenkel 114 in Durchlaufrichtung denkbar, wenn man weitere Maßnahmen der galvanischen Trennung von der Elektrolyse vornimmt.

## Patentansprüche

1. Einrichtung (11) zur Aufnahme bzw. Halterung mehrerer flacher Substrate (26) in einer horizontalen Ebene, mit einem Rahmen mit Rahmenschenkeln (12, 14), die Aufnahmefelder (20) zwischen sich bilden mit Ausnehmungen (20) bzw. Ausschnitten im Bereich der Rahmenschenkel bzw. dazwischen, wobei die Rahmenschenkel (12, 14) Auflagen (22, 24) für die Substrate (26) aufweisen zu deren mechanischer Halterung und zur elektrischen Kontaktierung (24) an die anliegende Substratseite.

2. Aufnahme-Einrichtung nach Anspruch 1, **dadurch gekennzeichnet, dass** die Auflagen Vorsprünge (22) sind, die von den Rahmenschenkeln (12, 14) abstehen, wobei die Vorsprünge (22) insbesondere unterhalb der Ebene der Rahmenschenkel verlaufen derart, dass die Substrate (26) auf ihnen aufliegen und dabei in etwa in einer Ebene mit der Aufnahme bzw. mit den Rahmenschenkeln (12, 14) liegen.

3. Aufnahme-Einrichtung nach Anspruch 1 oder 2, **dadurch gekennzeichnet, dass** die Auflagen (22) nach oben stehende Kontakte (24) aufweisen, insbesondere Kontaktvorsprünge oder Kontaktspitzen.

4. Aufnahme-Einrichtung nach einem der vorhergehenden Ansprüche, **dadurch gekennzeichnet, dass** zumindest ein Teil der Rahmenschenkel (12, 14), insbesondere alle Rahmenschenkel bzw. die Aufnahme-Einrichtung (11), elektrisch leitfähig ist, wobei sie vorzugsweise aus Metall besteht und wobei insbesondere elektrisch leitfähige Rahmenschenkel (12, 14) auch elektrisch leitend miteinander verbunden sind.

5. Aufnahme-Einrichtung nach Anspruch 4, **dadurch gekennzeichnet, dass** sie, insbesondere ihre Rahmenschenkel (12, 14), an ihrer Oberfläche zumindest großteils elektrisch isoliert sind, vorzugsweise durch eine Beschichtung.

6. Aufnahme-Einrichtung nach einem der vorhergehenden Ansprüche, **gekennzeichnet durch** einen von ihrem Außenbereich, insbesondere einem außen verlaufenden Rahmenschenkel (12), abstehenden Abschnitt (16, 17), wobei vorzugsweise der Abschnitt von der Ebene der Aufnahme-Einrichtung (11) nach oben hin (16) abgewinkelt ist und insbesondere nach oben und dann zur Seite (17).

7. Aufnahme-Einrichtung nach Anspruch 6, **dadurch gekennzeichnet, dass** der abstehende Abschnitt (16, 17) elektrisch leitfähig mit den Rahmenschenkeln (12, 14) und/oder den elektrischen Kontaktierungen (24) an die anliegenden Substrate (26) verbunden ist; wobei er insbesondere eine elektrisch leitfähige Oberfläche aufweist.

8. Aufnahme-Einrichtung nach einem der vorhergehenden Ansprüche, **dadurch gekennzeichnet, dass** sie einteilig ausgebildet ist, vorzugsweise einstückig.

9. Aufnahme-Einrichtung nach einem der vorhergehenden Ansprüche, **dadurch gekennzeichnet, dass** ein Substrat (26) derart dichtend in einem Aufnahmefeld (20) zwischen den angrenzenden Rahmenschenkeln (12, 14) liegt, dass es eine Ausnehmung zwischen den Rahmenschenkeln nach unten abdichtet bzw. verschließt gegen Durchdringen von Flüssigkeit mit geringem Druck.

10. Aufnahme-Einrichtung nach Anspruch 9, **gekennzeichnet durch** Dichtungen im Bereich der Rahmenschenkel (12, 14) zur Anlage an dem eingelegten Substrat (26).

11. Aufnahme-Einrichtung nach einem der vorhergehenden Ansprüche, **dadurch gekennzeichnet, dass** mehrere Aufnahmefelder (20) nebeneinander und hintereinander vorgesehen sind, wobei sie vorzugsweise gleich groß sind.

12. Aufnahme-Einrichtung nach einem der vorhergehenden Ansprüche, **gekennzeichnet durch** eine Abdeckeinrichtung, die an der Aufnahme-Einrichtung (11) befestigbar ist, wobei eingelegte Substrate (26) zwischen der Aufnahme-Einrichtung (11) und der Abdeckeinrichtung liegen und gegen Herausfallen gesichert sind, wobei insbesondere die Abdeckeinrichtung in etwa die gleiche Fläche bedeckt wie die Aufnahme-Einrichtung (11).

13. Galvanisiereinrichtung mit einer Durchlaufbahn für Substrate (26) durch eine Behandlungskammer (32), wobei die Behandlungskammer ein Behandlungsmedium wie einen Elektrolyten zum galvanischen Aufbringen einer Schicht auf die Substrate (26) aufweist, **dadurch gekennzeichnet, dass** die Durchlaufbahn Transportmittel wie Transportrollen (33) odgl. aufweist zum liegenden Hindurchtransportieren einer Aufnahme-Einrichtung (11) nach einem der vorhergehenden Ansprüche darauf.

14. Galvanisiereinrichtung nach Anspruch 13, **gekennzeichnet durch** von oben an den Aufnahme-Einrichtungen (11) bzw. Substraten (26) anliegende Andruckrollen (36), wobei in Durchlaufrichtung pro hintereinanderliegender Reihe von Substraten (26) mindestens eine Andruckrolle (36) vorgesehen ist und insbesondere die Andruckrollen sehr weich ausgebildet sind.

15. Galvanisiereinrichtung nach Anspruch 13 oder 14, **dadurch gekennzeichnet, dass** die Aufnahme-Einrichtung (11) nach einem der Ansprüche 1 bis 12 mit einem seitlichen Winkelabschnitt (16, 17) von der Ebene der Substrate (26) nach oben weg absteht und zu einer elektrischen Kontaktierung (42) reicht, vorzugsweise mit einem weiteren horizontalen Knick dazwischen, wobei insbesondere die elektrische Kontaktierung anliegende Kontaktrollen aufweist.

16. Galvanisiereinrichtung nach einem der Ansprüche 13 bis-15, **dadurch gekennzeichnet, dass** das Höhenniveau des Behandlungsmediums gerade an die Unterseite der in der Aufnahme-Einrichtung (11) befindlichen Substrate (26) heranreicht.

17. Galvanisiereinrichtung nach Anspruch 13 oder 14, **dadurch gekennzeichnet, dass** an der Oberseite der Aufnahme-Einrichtung (11), insbesondere zwischen Andruckrollen (36), mehrere Kontaktiermittel angeordnet sind, vorzugsweise als umlaufende Kontaktierrollen, wobei die Kontaktiermittel einen elektrischen Kontakt zu den Substraten (26) aufweisen.

18. Galvanisiereinrichtung nach Anspruch 17, **dadurch gekennzeichnet, dass** die Kontaktiermittel an in Transportrichtung verlaufenden Rahmenschenkeln (12, 14) anliegen, vorzugsweise mindestens ein Kontaktiermittel an jedem in Transportrichtung verlaufenden Rahmenschenkel, wobei insbesondere diese Rahmenschenkel höher sind als das Niveau der in der Aufnahme-Einrichtung (11) befindlichen Substrate (26).

19. Galvanisiereinrichtung nach Anspruch 18, **dadurch gekennzeichnet, dass** von den Rahmenschenkeln, an denen die Kontaktiermittel anliegen, zu den darin befindlichen Substraten (26) elektrische Kontaktbrücken verlaufen, vorzugsweise bügelartig von dem Rahmenschenkel beidseitig weg zu den Substraten, wobei insbesondere die Substrate auf Enden der Kontaktbrücken aufliegen.

20. Galvanisiereinrichtung nach einem der Ansprüche 17 bis 19, **dadurch gekennzeichnet, dass** zwischen jeweils einem Paar von Andruckrollen (36) eine Kontaktierrolle vorgesehen ist, vorzugsweise auf derselben Achse.

21. Galvanisiereinrichtung nach einem der Ansprüche 17 bis 20, **dadurch gekennzeichnet, dass** die Kontaktiermittel, vorzugsweise die Kontaktierrollen, federnd bzw. elastisch ausgebildet sind, insbesondere mit von einem festen Mittelteil federnd abstehenden Kontaktierflächen.

## Claims

1. A device (11) for receiving or holding several flat substrates (26) in one horizontal plane, having a frame with frame pieces (12, 14) which form between them reception zones (20) with recesses (20) or cutouts in the vicinity of the frame pieces or between them, the frame pieces (12, 14) having supports (22, 24) for the substrates (26) for mechanically holding the same and for electrical contacting (24) on the engaging substrate side.

2. The reception device according to claim 1, **characterized in that** the supports are projections (22) projecting from the frame pieces (12, 14), the projections (22) more particularly running below the plane of the frame pieces in such a way that the substrates (26) rest thereon and are roughly in one plane with the receptacle or with the frame pieces (12, 14).

3. The reception device according to claim 1 or 2, **characterized in that** the supports (22) have upwardly projecting contacts (24), particularly contact projections or contact points.

4. The reception device according to any of the preceding claims, **characterized in that** at least part of the frame pieces (12, 14) and in particular all the frame pieces or the reception device (11) are electrically conductive and are preferably made from metal and where in particular electrically conductive frame pieces (12, 14) are electrically conductively interconnected.

5. The reception device according to claim 4, **characterized in that** it and in particular its frame pieces (12, 14), are largely electrically insulated on their surface, preferably by a coating.

6. The reception device according to any of the preceding claims, **characterized by** a section (16, 17) projecting from the outer area thereof, particularly from an outside frame piece (12), and preferably the section is bent upwards (16) from the plane of the reception device (11) and in particular upwards and then to the side (17).

7. The reception device according to claim 6, **characterized in that** the projecting section (16, 17) is electrically conductively connected to the frame pieces (12, 14) and/or the electrical contacting means (24) on the engaging substrates (26), and in particular it has an electrically conductive surface.

8. The reception device according to any of the preceding claims, **characterized in that** it is integrally constructed, preferably in one piece.

9. The reception device according to any of the preceding claims, **characterized in that** a substrate (26) rests in sealing manner in a reception zone (20) between adjacent frame pieces (12, 14) in such a way that it downwardly seals or closes a recess between the frame pieces against penetration of liquid at low pressure.

10. The reception device according to claim 9, **characterized by** seals in the vicinity of the frame pieces (12, 14) for engagement on the inserted substrate (26).

11. The reception device according to any of the preceding claims, **characterized in that** there are several reception zones (20) in juxtaposed, successive manner and preferably of the same size.

12. The reception device according to any of the preceding claims, **characterized by** a covering device which can be fixed to the reception device (11), inserted substrates (26) being located between the reception device (11) and the covering device and are secured against dropping out, and in particular the covering device roughly covers the same surface area as the reception device (11).

13. An electroplating device with a passage path for the substrates (26) through a treatment chamber (32), which has a treatment medium such as an electrolyte for the galvanic application of a coating to the substrates (26), **characterized in that** the passage path has conveying means such as conveying rollers (33) or the like for the horizontal conveying through of a reception device (11) according to any of the preceding claims.

14. The electroplating device according to claim 13, **characterized by** pressure rollers (36) engaging from above on the reception devices (11) or substrates (26), there being provided at least one pressure roller (36) for each successive row of substrates (26) in the passage direction, and in particular the pressure rollers have a very flexible or soft construction.

15. The electroplating device according to claim 13 or 14, **characterized in that** the reception device (11) according to any of the claims 1 to 12 projects upwards with a lateral angular section (16, 17) away from the plane of substrates (26) and extends to an electrical contacting means (42), preferably with a further intermediate horizontal bend, and in particular the electrical contacting means has engaging contact rollers.

16. The electroplating device according to any of the claims 13 to 15, **characterized in that** the height level of the treatment medium extends just up to the underside of the substrates (26) located in reception device (11).

17. The electroplating device according to claim 13 or 14, **characterized in that** there are several contacting means on the top of the reception device (11), particularly between the pressure rollers (36) and they are preferably in the form of circumferential contacting rollers, the contacting means having an electrical contact with the substrates (26).

18. The electroplating device according to claim 17, **characterized in that** the contacting means engage on frame pieces (12, 14) running in the conveying direction and preferably at least one contacting means engages on each frame piece running in the conveying direction, and in particular said frame pieces are higher than the level of the substrates (26) in reception device (11).

19. The electroplating device according to claim 18, **characterized in that** electric contact bridges run from the frame pieces on which the contacting means engage up to the substrates (26) located therein, and preferably bilaterally and in bow-like manner away from the frame pieces to the substrates, and in particular the substrates rest on ends of the contact bridges.

20. The electroplating device according to any of the claims 17 to 19, **characterized in that** a contacting roller is provided between each pair of pressure rollers (36), preferably on the same shaft.

21. The electroplating device according to any of the claims 17 to 20, **characterized in that** the contacting means, preferably contacting rollers, have a resilient or elastic construction, particularly with contacting surfaces projecting resiliently from a solid central part.

## Revendications

1. Dispositif (11) destiné à loger ou encore à maintenir plusieurs substrats (26) plats dans un plan horizontal, avec un châssis présentant des branches de châssis (12, 14), qui forment entre elles des champs de logement (20) avec des évidements (20) ou encore des découpages dans le domaine des branches de châssis ou encore entre celles-ci, sachant que les branches de châssis (12, 14) présentent des supports (22, 24) pour les substrats (26) destinés à les soutenir mécaniquement et à créer un contact électrique (24) à leur face de substrat adjacente.

2. Dispositif de logement d'après la revendication 1, **caractérisé en ce que** les supports sont des saillies (22), qui se projettent à l'avant des branches de châssis (12, 14), sachant que les saillies (22) s'étendent notamment au-dessous du plan des branches de châssis, de façon que les substrats (26) reposent sur celles-ci et se trouvent à peu près dans le même plan que le logement ou encore que les branches de châssis (12, 14).

3. Dispositif de logement d'après la revendication 1 ou 2, **caractérisé en ce que** les supports (22) présentent des contacts (24) orientés vers le haut, notamment des saillies de contact ou des pointes de contact.

4. Dispositif de logement d'après une des revendications précédentes, **caractérisé en ce qu'**au moins une partie des branches de châssis (12, 14), notamment toutes les branches de châssis ou encore le dispositif de logement (11) sont électriquement conductifs, sachant qu'il est composé de préférence de métal et sachant que notamment des branches de châssis (12, 14) électriquement conductives sont également raccordées entre elles de façon électriquement conductive.

5. Dispositif de logement d'après la revendication 4, **caractérisé en ce que** celui-ci et notamment ses branches de châssis (12, 14), sont électriquement isolés au moins en grande partie à leur surface, de préférence au moyen d'un revêtement.

6. Dispositif de logement d'après une des revendications précédentes, **caractérisé par** un secteur (16, 17) qui saille de la zone extérieure du dispositif de logement, notamment à partir d'une branche de châssis (12) qui se trouve au périmètre, sachant que de préférence le secteur est coudé vers le haut (16) et notamment d'abord vers le haut et puis de côté (17) à partir du plan du dispositif de logement (11).

7. Dispositif de logement d'après la revendication 6, **caractérisé en ce que** le secteur saillant (16, 17) est électriquement raccordé par les branches de châssis (12, 14) et/ou par les contacts électriques (24) aux substrats (26) adjacents, sachant qu'il présente notamment une surface électriquement conductive.

8. Dispositif de logement d'après une des revendications précédentes, **caractérisé en ce que** celui-ci est réalisé d'une seule partie, de préférence d'une seule pièce.

9. Dispositif de logement d'après une des revendications précédentes, **caractérisé en ce qu'**un substrat (26) est situé dans un champ de logement (20) entre les branches de châssis (12, 14) limitrophes de manière tellement étanchante, qu'il scelle hermétiquement vers le bas un évidement entre les branches de châssis ou encore le bouche contre une pénétration de liquides soumis à une basse pression.

10. Dispositif de logement d'après la revendication 9, **caractérisé par** des joints dans le domaine des branches de châssis (12, 14) pour un contact étroit avec le substrat (26) inséré.

11. Dispositif de logement d'après une des revendications précédentes, **caractérisé en ce qu'**on prévoit plusieurs champs de logement (20) l'un à côté de l'autre et l'un derrière l'autre, sachant que de préférence ils présentent les mêmes dimensions.

12. Dispositif de logement d'après une des revendications précédentes, **caractérisé par** un dispositif de recouvrement, pouvant être fixé au dispositif de logement (11), sachant que des substrats (26) insérés se trouvent entre le dispositif de logement (11) et le dispositif de recouvrement et qu'ils sont assurés contre leur sortie, sachant notamment que le dispositif de recouvrement recouvre à peu près la même surface que le dispositif de logement (11).

13. Dispositif de galvanisation avec une voie de transfert pour substrats (26) à travers une chambre de traitement (32), sachant que la chambre de traitement présente une substance de traitement, comme un électrolyte, pour l'application galvanique d'une couche sur les substrats (26), **caractérisé en ce que** la voie de transfert présente des moyens de transport comme des rouleaux de transport (33) ou similaires pour y transporter dessus en position horizontale un dispositif de logement (11) d'après une des revendications précédentes.

14. Dispositif de galvanisation d'après la revendication 13, **caractérisé par** des rouleaux de pression (36) qui s'appuient par le haut sur les dispositifs de logement (11) ou encore sur les substrats (26), sachant qu'en direction de passage on prévoit au moins un rouleau de pression (36) par rangée consécutive de substrats (26) et que notamment les rouleaux de pression sont réalisés de manière à être très souples.

15. Dispositif de galvanisation d'après la revendication 13 ou 14, **caractérisé en ce que** le dispositif de logement (11) d'après une des revendications de 1 à 12 saille vers le haut du plan des substrats (26) au moyen d'un secteur coudé (16, 17) latéral et suffit à établir un contact (42), de préférence avec un coude horizontal additionnel intermédiaire, sachant que notamment le moyen d'établissement de contact électrique présente des galets de contact adjacents.

16. Dispositif de galvanisation d'après une des revendications de 13 à 15, **caractérisé en ce que** le niveau de la substance de traitement atteint juste la face inférieure des substrats (26) situés dans le dispositif de logement (11).

17. Dispositif de galvanisation d'après la revendication 13 ou 14, **caractérisé en ce qu'**à la face supérieure du dispositif de logement (11), notamment entre des rouleaux de pression (36) plusieurs moyens d'établissement de contact sont disposés de préférence sous forme de galets de contact rotatoires, sachant que les moyens d'établissement de contact présentent un contact électrique avec les substrats (26).

18. Dispositif de galvanisation d'après la revendication 17, **caractérisé en ce que** les moyens d'établissement de contact sont adjacents à des branches de châssis (12, 14) qui s'étendent en direction de transport, de préférence au moins un moyen d'établissement de contact à chaque branche de châssis s'étendant en direction de transport, sachant que notamment ces branches de châssis dépassent en hauteur le niveau des substrats (26) situés dans le dispositif de logement (11).

19. Dispositif de galvanisation d'après la revendication 18, **caractérisé en ce que** à partir des branches de châssis auxquelles les moyens d'établissement de contact sont adjacents jusqu'aux substrats (26) situés à l'intérieur de celles-ci s'étendent des ponts de contact, de préférence à la façon d'un étrier à partir des deux côtés de la branche de châssis vers les substrats, sachant que notamment les substrats reposent sur des extrémités des ponts de contact.

20. Dispositif de galvanisation d'après une des revendications de 17 à 19, **caractérisé en ce qu'**on prévoit respectivement un galet de contact entre une paire de rouleaux de pression (36), de préférence sur un même arbre.

21. Dispositif de galvanisation d'après une des revendications de 17 à 20, **caractérisé en ce que** les moyens d'établissement de contact, de préférence les galets de contact, sont réalisés à la manière d'un ressort ou encore de façon élastique, notamment avec des surfaces d'établissement de contact qui saillent élastiquement à ressort à partir d'une partie centrale fixe.
